# EUROPEAN PATENT APPLICATION

(11) **EP 2 405 475 A1**
(43) Date of publication of application: **11.01.2012**
(21) Application number: 10174351.6
(22) Date of filing: 27.08.2010
(51) Int. Cl.: H01L 21/67, H01L 21/687

(54) **Plasma texturing apparatus**

(30) Priority: 07.07.2010 KR 20100065252
(71) Applicant: Semi-Materials Co., Ltd, Seongnam-si, Gyeonggi-do 440-746 (KR)
(72) Inventor: Park, Kun Joo, Gyeonggi-do (KR); Kim, Yong Gab, Gyeongsangbuk-do (KR); Kim, Gi Hong, Daegu-si (KR); Park, Kun, Gyeonggi-do (KR)
(74) Representative: Neobard, William John

(57) **Abstract**

A plasma texturing apparatus for a solar cell includes a susceptor having engagement projections to prevent a wafer mounted therein from slipping outward or fluctuating back and forth when aligning the wafer over a cathode for plasma texturing; a focus ring functioning to confine plasma when conducting a plasma texturing process; and a clamp placed on an inner surface of the focus ring in such a way as to have a downward slope, and having one end which is coupled to the focus ring and the other end which faces away from the one end, is formed to be pointed and functions to squeeze and support peripheral portions of the wafer.

## Description

The present invention relates to the field of surface texturing of a substrate, I and to the field of texturing for solar cell manufacture. More specifically but not exclusively the invention concerns a plasma texturing apparatus and method for a solar cell, which can prevent the warpage of a wafer from occurring by thermal expansion of silicon when conducting plasma texturing through dry etching on a solar cell wafer to increase a light absorption amount of available light to the inside of a solar cell by reducing a light reflection amount on the surface of the solar cell.

A solar cell is a photoelectric element which converts light energy into electrical energy. The solar cell is considered as a clean energy source which can overcome problems such as environmental pollution, high fuel cost,, etc. caused due to the use of fossil fuel energy.

In general, a P-type silicon wafer, I which has a crystal orientation of <100> or <111>, is used as a semiconductor substrate for a solar cell. The P-type silicon wafer has a thickness of approximately 200 µm.

Recently, research has been actively conducted to improve the photoelectric conversion efficiency of a solar cell. As a way of improving the photoelectric conversion efficiency of a solar cell, wet chemical texturing is conducted on a solar cell wafer so as to decrease a light reflection amount on the surface of a solar cell and increase a light absorption amount of available light to the inside of the solar cell. By this fact, pyramid shapes with a size of 4-10 µm are formed on the surface of the solar cell wafer.

In the case where surface texturing is conducted through wet chemical etching as described above, both surfaces of the wafer are etched. Generally, while it is required that a wafer for a solar cell has a thickness of no less than 200 µm, if the surface texturing through wet chemical etching is conducted for an ultrathin wafer (a wafer with a thickness of no greater than 200 µm), breakage of the wafer can be caused as both surfaces of the wafer are etched. As a consequence, it is difficult to apply surface texturing to an ultrathin substrate such as a silicon wafer.

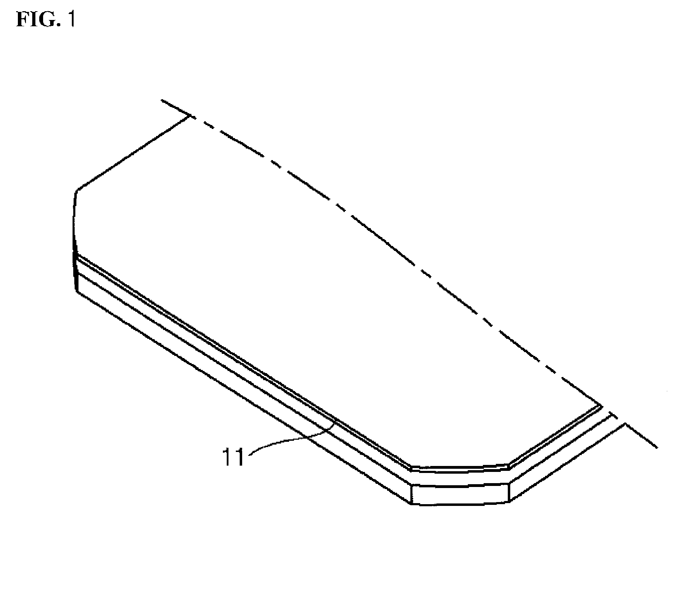

For this reason, plasma texturing can be considered as an alternative of the wet chemical texturing. Nevertheless, when conducting the plasma texturing, a substrate such as wafer 11 is likely to warp as shown in FIG. 1 due to the thermal expansion of the material - in this case silicon. Therefore, adverse influences are imposed on the device performance and the reliability of a solar cell and on subsequent processes, whereby the degradation of the solar cell is caused.

If instead surface texturing of a solar cell wafer is conducted through dry etching, since only one surface of the substrate/wafer is etched, the breakage of the wafer can be prevented even when the surface texturing through dry etching is applied to an ultrathin wafer with a thickness of no greater than 200 µm.

In order to conduct the surface texturing for the surface of the solar cell wafer through dry etching, a wafer is placed over a cathode assembly in a vacuum chamber. At this time, in the case where a wafer is held through ESC (electrostatic charging) as an electrical floating method mainly used in semiconductor manufacturing processes, the breakage of the solar cell wafer is likely to occur due to stickiness induced by charging of the cathode assembly and the wafer. Also, when conducting dry etching after placing the wafer on a susceptor, the wafer is likely to warp due to thermal expansion coefficient by plasma ion reaction. Due to this fact, the etching uniformity of the center portion and the peripheral portions of a semiconductor substrate is likely to deteriorate, which is problematic.

An embodiment of the present invention provides a plasma texturing apparatus and method for a solar cell, which can prevent a substrate from warping by thermal expansion due to plasma ion reaction when texturing through dry etching an ultrathin substrate for a relatively thin cell, and the etching uniformity of the substrate from degrading.

In one aspect of the present invention, there is provided a plasma texturing apparatus for a solar cell, including: a susceptor having engagement projections to prevent a wafer mounted therein from slipping outward or fluctuating back and forth when aligning the wafer over a cathode for plasma texturing; a focus ring functioning to confine plasma when conducting a plasma texturing process; and a clamp placed on an inner surface of the focus ring in such a way as to have a downward slope, and having one end which is coupled to the focus ring and the other end which faces away from the one end, is formed to be pointed and functions to squeeze and support peripheral portions of the wafer.

In another aspect of the present invention there is provided a plasma texturing method for a solar cell, including the steps of: (a) using a susceptor formed with engagement projections to prevent a wafer for undergoing a plasma texturing process from slipping outward or fluctuating back and forth, when mounting the wafer in the susceptor and moving the wafer to a position of a plasma etcher load lock; (b) moving the susceptor into a vacuum chamber; (c) lifting lift pins and aligning the susceptor over a cathode; (d) lowering a clamp integrally formed with a focus ring, and squeezing and supporting peripheral portions of the wafer by a pointed end of the clamp which is formed on one end of the clamp; and (e) introducing a gas into the chamber, producing plasma, and beginning texturing.

In the drawings:
FIG. 1 is a schematic view illustrating a wafer warping phenomenon occurring in a conventional plasma texturing apparatus for a solar cell;
FIG. 2 is a perspective view schematically illustrating a plasma texturing apparatus for a solar cell in accordance with an embodiment of the present invention;
FIG. 3 is a plan view illustrating the plasma texturing apparatus for a solar cell in accordance with the embodiment of the present invention;
FIG. 4 is a longitudinal cross-sectional view taken along the line A-A of FIG. 2;
FIGs. 5 and 6 are schematic views illustrating a state in which a wafer, a clamp and a focus ring operate in a cooperative manner;
FIG. 7 is a plan view illustrating a susceptor according to the present invention; and
FIG. 8 is a flow chart illustrating a plasma texturing method for a solar cell in accordance with another embodiment of the present invention.

Reference will now be made in greater detail to preferred embodiments of the invention, examples of which are illustrated in the accompanying drawings. Wherever possible, the same reference numerals will be used throughout the drawings and the description to refer to the same or like parts.

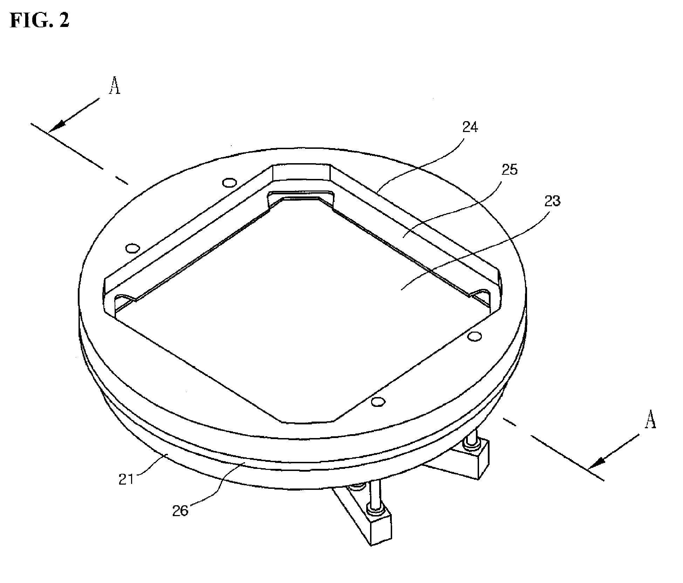

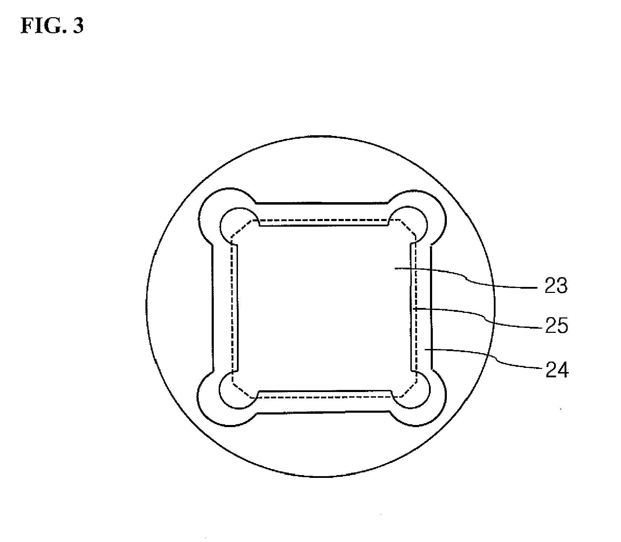

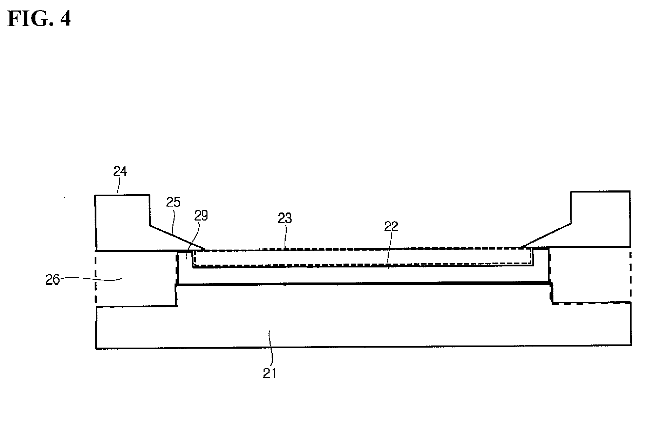

FIG. 2 is a perspective view schematically illustrating a plasma texturing apparatus for a solar cell in accordance with an embodiment of the present invention, FIG. 3 is a plan view illustrating the plasma texturing apparatus for a solar cell in accordance with the embodiment of the present invention, and FIG. 4 is a longitudinal cross-sectional view taken along the line A-A of FIG. 2. Referring to FIGs. 2 through 4, a plasma texturing apparatus for a solar cell in accordance with an embodiment of the present invention includes a cathode 21, a susceptor 22, a wafer 23, a focus ring 24, a clamp 25, and a ceramic insulator ring 26.

FIG. 4, which is a longitudinal cross-sectional view of the plasma texturing apparatus for a solar cell according to the present invention, illustrates a state in which the wafer 23 is moved into a chamber and preparation for conducting a texturing procedure is completed.

Engagement projections 29 are upwardly formed on the peripheral portions of the susceptor 22 in which the wafer 23 is to be mounted. By this fact, when the wafer 23 is moved into the chamber, the wafer 23 is prevented from slipping outward or fluctuating back and forth and is maintained in a fixed state, due to the presence of the engagement projections 29. The engagement projections 29 can be formed entirely or partially along the four sides of the susceptor 22.

The focus ring 24 functions to increase the density of plasma for etching the peripheral portions of the wafer 23. The clamp 25 which has a downward slope is coupled to the inner surface of the focus ring 24. The clamp 25 functions to squeeze and support the peripheral portions of the wafer 23 which is mounted in the susceptor 22 and is aligned over the cathode 21.

While FIG. 4 exemplarily shows that the clamp 25 squeezes and supports the peripheral portions of the wafer 23 on the engagement projections 29 of the susceptor 22, in the case where the engagement projections 29 are partially formed along the four sides of the susceptor 22, portions of the clamp 25, which are formed between the engagement projections 29, can squeeze and support the peripheral portions of the wafer 23 except the peripheral portions of the wafer 23 corresponding to the engagement projections 29.

Referring to FIGs. 2 and 3, in the clamp 25 which is coupled to the inner surface of the focus ring 24 and has a downward slope, the portion of the clamp 25 which defines a height is coupled to the focus ring 24, and the opposite pointed portion of the clamp 25 squeezes and supports the peripheral portions of the wafer 23.

While the angle of the downward slope of the clamp 25 is specifically limited, it is preferred that the angle be set to no greater than 45°. If the angle is too great, the peripheral portions of the wafer 23 may not be sufficiently etched due to ion trajectory. Also, it is preferred that the height of the focus ring 24 be set to no greater than 20 mm.

While the clamp 25 can squeeze and support the entirety of the peripheral portions of the wafer 23, it can be envisaged in another embodiment that, in the case where the susceptor 22 is fabricated to have a size smaller than the wafer 23, the clamp 25 can squeeze and support only the peripheral portions of the wafer 23 under which the susceptor 22 is placed.

The wafer 23 includes an ultrathin wafer which has a thickness of no greater than 200 µm. Since the peripheral portions of the wafer 23 are squeezed and supported by the clamp 25 as described above, a phenomenon in which the wafer 23 warps is prevented from occurring even when a temperature rises due to plasma ion reaction.

Etching uniformity changes in the center portion and the peripheral portions of the wafer 23 depending upon the height of the focus ring 24 and the slope of the clamp 25. By using this fact, the uniform texturing of the wafer 23 can be ensured, and thereby, photoelectric conversion efficiency of a solar cell can be improved.

For reference, the peripheral portions of the wafer 23 indicate band-shaped portions which have a width of about 1 mm measured from the edges of the wafer 23. Because the peripheral portions of the wafer 23 are laser-scribed for edge isolation after an etching process for removing a thin PSG (phosphosilicate glass) layer produced during an impurity applying process is finished, no adverse effects are caused even though the peripheral portions of the wafer 23 are squeezed and supported by the clamp 25.

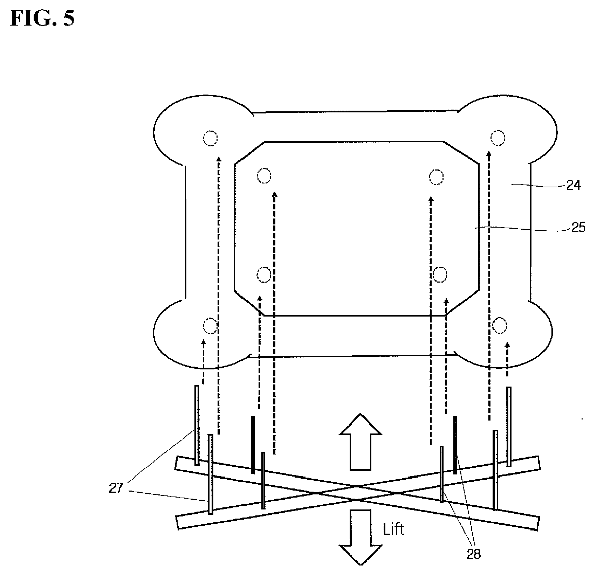

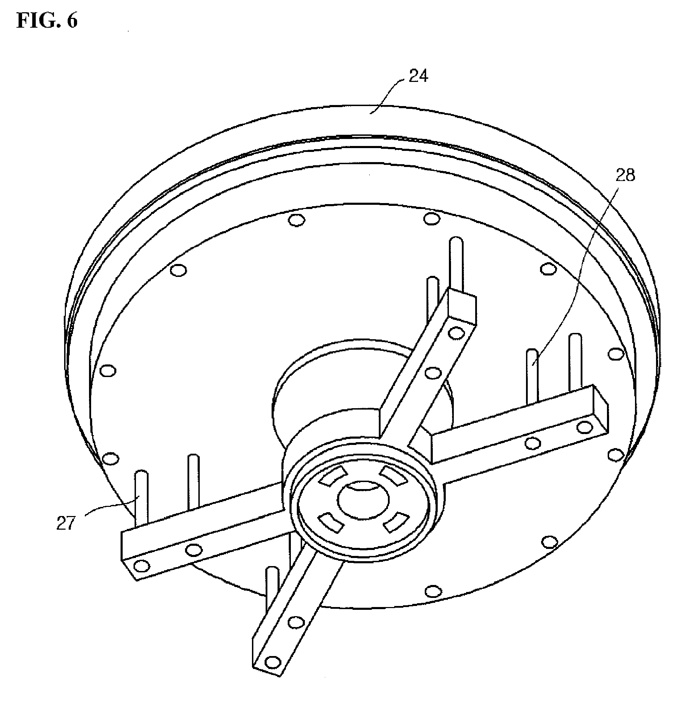

When the wafer 23 is moved into the chamber for plasma texturing and is loaded over the cathode 21, susceptor lift pins 28 are lifted to support the wafer 23. At this time, FIGs. 5 and 6 illustrate a state in which the wafer 23, the clamp 25 and the focus ring 24 operate in a cooperative manner.

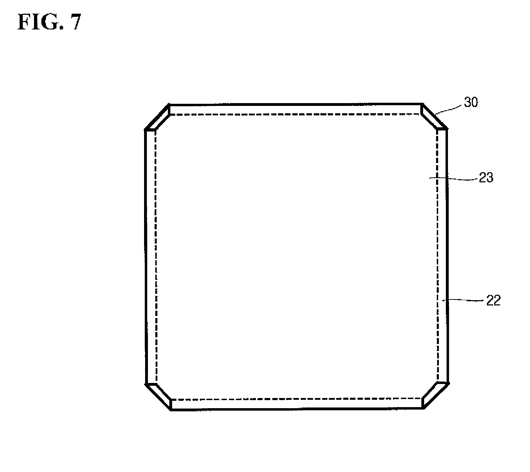

When using an ultrathin wafer for a solar cell, not only warpage of the wafer is likely to frequently occur during plasma processing, but also breakage of the wafer is likely to frequently occur due to ion charging during texturing. FIG. 7 is to explain an example of realizing a susceptor according to the present invention for stably controlling the wafer 23 and thereby preventing the breakage of the wafer 23 from occurring. In other words, it is preferred that aluminum and ceramic, which have excellent heat transfer capability for ensuring rapid cooling, be used as materials of the susceptor 22 and the susceptor 22 be coated with A1203 or Y203 to suppress the production of particles. Further, it is preferred that the surface of the susceptor 22 be roughened so as to prevent slippage of the wafer 23.

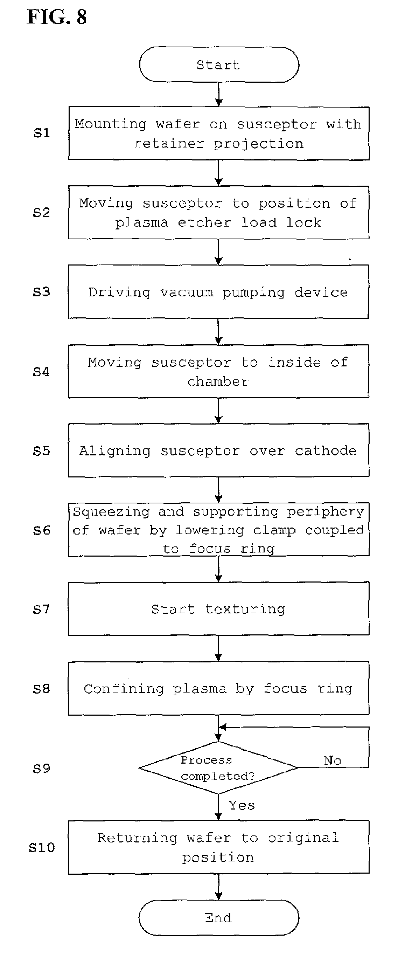

A plasma texturing method for a solar cell in accordance with another embodiment of the present invention will be described with reference to FIG. 8.

First, the wafer 23 to undergo a plasma texturing process is placed on the susceptor 22 by a worker (S1). The susceptor 22 is formed with the engagement projections 29 for preventing the wafer 23 from slipping outward or fluctuating back and forth.

Thereafter, the susceptor 22 having the wafer 23 mounted therein is loaded in a cassette (not shown) and is moved to the position of a plasma etcher load lock (S2).

A pumping device is driven to keep the inside of a chamber for conducting a plasma texturing process, under a vacuum condition (S3).

After pumping operation is completed and the inside of the chamber is kept under a vacuum condition, the susceptor 22 having the wafer 23 mounted therein is moved into the chamber by a transfer robot arm (not shown) (S4).

Since the engagement projections 29 are formed on the peripheral portions of the susceptor 22 as shown in FIG. 4, when the wafer 23 is moved into the chamber, the wafer 23 is prevented from slipping outward or fluctuating back and forth and is maintained in a fixed state, due to the presence of the engagement projections 29.

In this state, as shown in FIGs. 5 and 6, focus ring lift pins 27 and the susceptor lift pins 28 are lifted. By this fact, after the susceptor 22 is supported by the susceptor lift pins 28, the susceptor 22 is aligned over the cathode 21 (S5).

Thereupon, the clamp 25 is lowered to be positioned over the susceptor 22, and squeezes and supports the peripheral portions of the wafer 23 which is aligned over the cathode 21 (S6) .

With the peripheral portions of the wafer 23 squeezed and supported by the clamp 25 in this way, a gas is introduced into the chamber, and plasma is produced, by which texturing begins (S7).

The focus ring 24 functions to confine plasma. Also, as the clamp 25 coupled to the focus ring 24 squeezes and supports the peripheral portions of the wafer 23, the peripheral portions of the wafer 23 are prevented from warping, and texturing can be uniformly conducted (S8).

If the plasma texturing of the wafer 23 is completed through the series of above-described processes, the wafer 23 is returned to its original position through a reverse course (S9 and S10).

While it was exemplified in the above description that the embodiment is applied to the texturing of a solar cell, it is to be noted that the present invention is not limited to such application and can be applied to an LED, CVD, etc. where thermal or mechanical stress can be applied to a thin wafer.

As is apparent from the above description, the plasma texturing apparatus and method according to the present invention provide advantages in that, since the peripheral portions of a wafer are supported by being squeezed by a clamp when texturing the surface of an ultrathin wafer through dry etching in the manufacturing procedure of a solar cell, it is possible to prevent the wafer from warping, and since etching uniformity of the center portion and the peripheral portions of the wafer is increased, the reflectance of the solar cell manufactured through texturing the surface of the wafer is decreased, whereby the photoelectric conversion efficiency of the solar cell can be improved.

Also, due to the fact that a clamp and a focus ring are integrated with each other and operate by being interlocked with the operation of lift pins of a cathode assembly, the construction of the plasma texturing apparatus and processing by the apparatus can be simplified.

Although preferred embodiments of the present invention have been described for illustrative purposes, those skilled in the art will appreciate that various modifications, additions and substitutions are possible, without departing from the scope of the invention as recited in the accompanying claims.

## Claims

1. A plasma texturing apparatus for a solar cell, comprising:
a susceptor having engagement projections to prevent a wafer mounted therein from slipping outward or fluctuating back and forth when aligning the wafer over a cathode for plasma texturing;
a focus ring functioning to confine plasma when conducting a plasma texturing process; and
a clamp placed on an inner surface of the focus ring in such a way as to have a downward slope, and having one end which is coupled to the focus ring and the other end which faces away from the one end, is formed to be pointed and functions to squeeze and support peripheral portions of the wafer.

2. The plasma texturing apparatus according to claim 1, wherein the wafer comprises an ultrathin wafer which has a thickness of no greater than 200 µm.

3. The plasma texturing apparatus according to claim 1 or 2, wherein the engagement projections of the susceptor are formed entirely or partially in correspondence to the peripheral portions of the wafer.

4. The plasma texturing apparatus according to claim 1, 2 or 3 wherein the susceptor is formed of aluminum and ceramic.

5. The plasma texturing apparatus according to any preceding claim, wherein the susceptor is coated with Y203.

6. The plasma texturing apparatus according to any preceding claim , wherein the downward slope of the clamp has an angle of no greater than 45°.

7. The plasma texturing apparatus according to any preceding claim, wherein the clamp squeezes and supports the peripheral portions of the wafer by a width of no greater than 1 mm.
